Europäisches Patentamt

European Patent Office

Office européen des brevets

(19)

(11) **EP 1 037 770 B1**

(12) **EUROPÄISCHE PATENTSCHRIFT**

(45) Veröffentlichungstag und Bekanntmachung des Hinweises auf die Patenterteilung:
**10.07.2002 Patentblatt 2002/28**

(21) Anmeldenummer: **99939358.0**

(22) Anmeldetag: **17.06.1999**

(51) Int Cl.⁷: **B60R 21/00**

(86) Internationale Anmeldenummer:
**PCT/DE99/01779**

(87) Internationale Veröffentlichungsnummer:
**WO 00/03896 (27.01.2000 Gazette 2000/04)**

(54) **VERFAHREN UND SCHALTUNGSANORDNUNG ZUM ÜBERWACHEN EINES ZÜNDKREISES FÜR EINE SICHERHEITSEINRICHTUNG IN EINEM FAHRZEUG**

METHOD AND CIRCUIT FOR MONITORING A PRIMER CIRCUIT IN THE SAFETY SYSTEM OF A VEHICLE

PROCEDE ET CIRCUIT POUR SURVEILLER UN CIRCUIT D'AMORCAGE D'UN SYSTEME DE SECURITE DANS UN VEHICULE

(84) Benannte Vertragsstaaten:
**DE FR GB IT SE**

(30) Priorität: **16.07.1998 DE 19832019**

(43) Veröffentlichungstag der Anmeldung:
**27.09.2000 Patentblatt 2000/39**

(73) Patentinhaber: **ROBERT BOSCH GMBH**
**70442 Stuttgart (DE)**

(72) Erfinder:
• **SCHUMACHER, Hartmut**
**D-71691 Freiberg (DE)**
• **RINGGER, Klaus**
**D-72662 Nürtingen (DE)**

(56) Entgegenhaltungen:
**EP-A- 0 338 413      EP-A- 0 577 988**
**EP-A- 1 047 582      WO-A-96/07562**

EP 1 037 770 B1

## Beschreibung

Stand der Technik

Die vorliegende Erfindung betrifft ein Verfahren und eine Schaltungsanordnung zum Überwachen eines Zündkreises für eine Sicherheitseinrichtung in einem Fahrzeug, wobei der ohmsche Widerstand eines mit einer Kapazität in Reihe geschalteten Zündelements dadurch gemessen wird, daß die Kapazität über eine vorgebbare Ladezeit mit einem Meßstrom aufgeladen wird, am Ende des Aufladevorgangs eine erste am Zündkreis abfallende Zündkreisspannung und nach Abschalten des Meßstromes eine zweite Zündkkreisspannung erfaßt werden und daß aus den beiden Zündkreisspannungen und dem Meßstrom der Widerstand des Zündelements ermittelt wird.

Ein derartiges Verfahren geht aus der nicht vorveröffentlichten EP-A-1 047 582 hervor. Damit gewährleistet ist, daß der Zündkreis einer Sicherheitseinrichtung (z. B. Airbag, Gurtstraffer) im Falle eines Crashes fehlerfrei funktioniert, muß der Zündkreis laufend überwacht werden. Ein Fehler des Zündkreises wird im Fahrzeug optisch oder akustisch angezeigt. In der Praxis können zum Beispiel folgende Fehler im Zündkreis auftreten: Zwischen dem Zündelement und der Batteriespannung oder der Masse kann ein Kurzschluß entstehen. Außerdem können Nebenschlüsse zwischen den Zuleitungen des Zündkreises selbst oder parallel zum Zündkreiskondensator auftreten. All diese Fehler äußern sich dadurch, daß der ohmsche Widerstand des Zündkreises von einem bekannten Sollwert abweicht. Deshalb wird gemäß der älteren deutschen Anmeldung 198 02 042.2 der ohmsche Widerstand des Zündelements in periodisch sich wiederholenden Abständen gemessen und überprüft, ob eine Sollwertabweichung vorliegt. Da hierbei der Widerstand des Zündelements aus Spannungen abgeleitet wird, die sich zu verschiedenen Ladezuständen der mit dem Zündelement in Reihe geschalteten Kapazität ergeben, hängt die Widerstandmessung sehr stark von Kapazitätsschwankungen, die zum Beispiel herstellungsbedingt sind oder durch unterschiedliche Temperatureinflüsse zustande kommen, ab.

Der Erfindung liegt daher die Aufgabe zugrunde, ein Verfahren und eine Schaltungsanordnung der eingangs genannten Art anzugeben, womit eine präzise Messung des Widerstandes des Zündelements unabhängig von Schwankungen der im Zündkreis befindlichen Kapazität möglich ist.

Vorteile der Erfindung

Die genannte Aufgabe wird mit den Merkmalen des Anspruchs 1 bzw. 3 dadurch gelöst, daß die Ladezeit für die Kapazität im Zündkreis so bemessen wird, daß die zweite Zündkreisspannung, die kurz nach Abschalten des Meßstromes gemessen wird, einem fest vorgegebenen Wert entspricht. Wenn die Kapazität immer so lange aufgeladen wird, daß die zweite nach dem Abschalten des Meßstromes gemessene Zündspannung einen festen Wert annimmt, so läßt sich der ohmsche Widerstand des Zündelements exakt messen, ohne daß dabei Schwankungen der Zündkreiskapazität einen Einfluß haben.

Eine vorteilhafte Ausbildung des Verfahrens bzw. der Schaltungsanordnung geht aus dem Anspruch 2 bzw. 4 hervor.

Danach wird vor dem Meßvorgang für die beiden Zündkreisspannungen die Ladezeit dadurch bestimmt, daß die Kapazität über eine feste Grundladezeit aufgeladen wird, danach der Meßstrom abgeschaltet und dann die am Zündkreis abfallende Spannung gemessen wird. Diese gemessene Spannung wird mit einer Sollspannung verglichen, und in Abhängigkeit von der Differenz zwischen diesen Spannungen wird eine Korrekturladezeit ermittelt, aus der durch Addition mit der Grundladezeit eine Ladezeit entsteht, die gewährleistet, daß die beim anschließenden Meßvorgang gemessene zweite Zündkreisspannung dem fest vorgegebenen Wert entspricht.

Dieser Meßvorgang läßt sich mit einer einfach aufgebauten Schaltung realisieren, die keine aufwendige Stromquelle für die Aufladung der Kapazität im Zündkreis erfordert.

Beschreibung eines Ausführungsbeispiels

Anhand eines in der Zeichnung dargestellten Ausführungsbeispiels wird nachfolgend die Erfindung näher erläutert. Es zeigen:

Figur 1 eine Schaltungsanordnung zum Messen des Zündelement-Widerstandes,
Figur 2 einen Verlauf der Zündkreisspannung und
Figur 3 ein Flußdiagramm des Verfahrensablaufs zur Ermittlung des Zündelementwiderstandes.

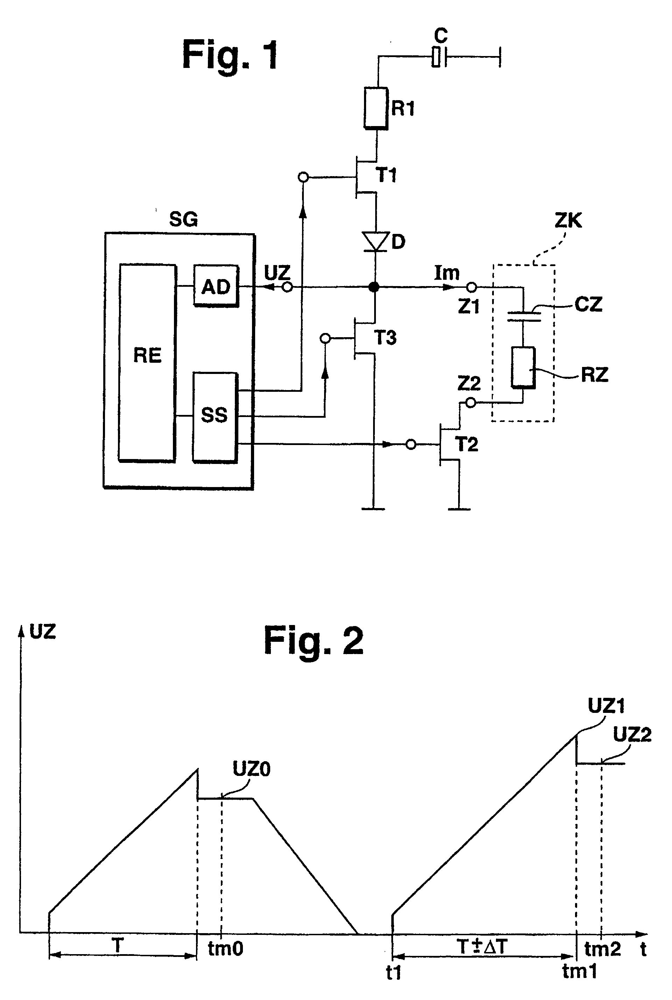

Die in der Figur 1 dargestellte Schaltungsanordnung enthält einen Wechselstromzündkreis ZK für eine Rückhalteeinrichtung (z.B. Airbag, Gurtstraffung). Dieser Zündkreis ZK besteht aus dem ohmschen Widerstand RZ eines Zündelements und einer dazu in Reihe geschalteten Kapazität CZ. Ein erster Anschlußpunkt Z1 des Zündkreises ZK ist mit der Reihenschaltung aus einer Diode D, einem elektronischen Schalter T1, einem Widerstand R1 und einer Energiereserve C in Gestalt eines Elektrolytkondensators geschaltet. Der Elektrolytkondensator C bildet zusammen mit dem in Reihe geschalteten hochohmschen Widerstand R1 eine Stromquelle, die entweder den Zündstrom für das Zündelement RZ des Zündkreises ZK oder einen Meßstrom Im für die Überwachung des Zündkreises ZK liefert. Während eine der beiden Elektroden der Kapazität C an den Widerstand R1 angeschlossen ist, ist die andere Elektrode mit Masse verbunden. Mit Hilfe des elektronischen Schalters T1, vorzugsweise eines Feldeffekttransistors, kann der Meßstrom Im an den Zündkreis ZK durchgeschaltet oder abgeschaltet werden. Die Diode D hat die Funktion eines Verpolschutzes, um den Transistor T1 vor Beschädigung durch überhöhte Spannung zu schützen, die beim Zünden des Zündkreises Zk entstehen kann.

Der erste Anschlußpunkt Z1 des Zündkreises ZK ist ebenfalls an ein Steuergerät SG angeschlossen, in dem die am Zündkreis ZK abfallende Zündkreisspannung UZ erfaßt und, wie weiter unten noch näher erläutert wird, ausgewertet wird, um den ohmschen Widerstand RZ des Zündelements zu ermitteln. Weiterhin ist an den ersten Anschlußpunkt Z1 des Zündkreises ZK ein elektronischer Schalter T3, vorzugsweise ein Feldeffekttransisitor angeschlossen, mit dem der Anschlußpunkt Z1 an Masse durchgeschaltet werden kann.

Der zweite Anschlußpunkt Z2 ist mit einem elektronischen Schalter T2, der vorzugsweise wie die beiden anderen Schalter T1 und T3 ebenfalls ein Feldeffekttransistor ist, geschaltet, womit der zweite Anschlußpunkt Z2 an Masse durchgeschaltet werden kann.

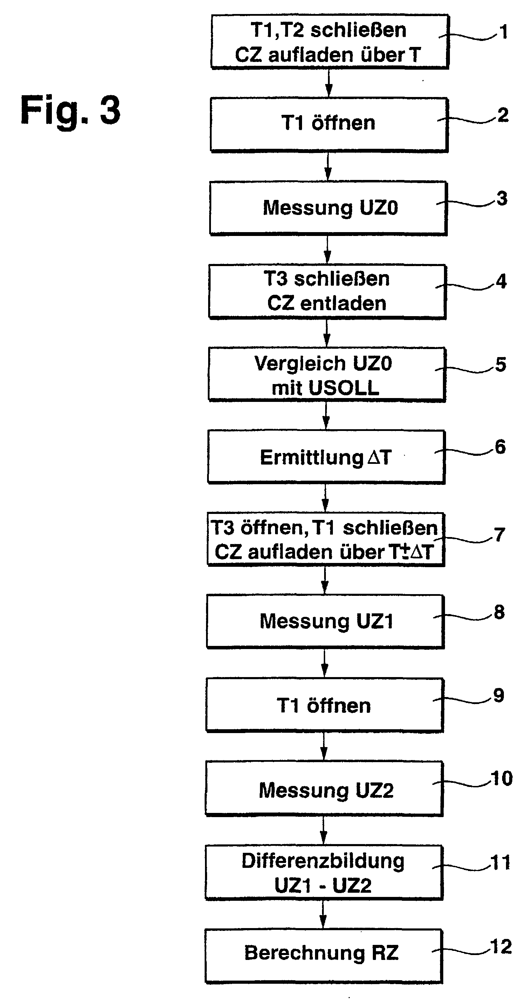

In dem Steuergerät SG befindet sich eine Recheneinheit RE, ein Analog-Digital-Umsetzer AD, der die Zündkreisspannung UZ in einem von der Recheneinheit RE verarbeitbares digitales Signal umsetzt. Außerdem ist eine an die Recheneinheit RE angeschlossene Schnittstelle SS vorhanden, von der aus den Transistoren T1, T2, T3 Steuersignale an deren Steuerelektroden (Gates) zugeführt werden. Das vom Steuergerät SG durchgeführte Verfahren zur Ermittlung des Widerstandes RZ des Zündelements wird nun anhand des in der Figur 2 dargestellten Verlaufs der Zündkreisspannung UZ und des Flußdiagramms in Figur 3 beschrieben.

Ausgehend davon, daß der Zündkreiskondensator CZ vollständig entladen ist, werden in einem ersten Verfahrensschritt die Schalter T1 und T2 geschlossen, so daß sich der Zündkreiskondensator CZ auflädt. Der Ladevorgang erstreckt sich über eine Ladezeit T, die nachfolgend als Grundladezeit bezeichnet werden soll. Wie aus der Figur 2 hervorgeht, steigt damit die am Zündkreis ZK abfallende Spannung UZ an. Die zeitlichen Verläufe der Zündkreisspannung UZ sind in der Figur 2 einfachheitshalber idealisiert und gradlinig gezeichnet. In der Realität verlaufen aber Lade- und Entladespannungen von Kapazitäten in Form einer e-Funktion. Bei der Wahl der Grundladezeit T, die in der Recheneinheit RE als fester Wert abgespeichert ist, ist darauf zu achten, daß die bei diesem Ladevorgang in der Kapazität CZ gespeicherte Energie keinesfalls ausreicht, um das Zündelement zu aktivieren.

Nach der Grundladezeit T wird in einem zweiten Verfahrensschritt der Schalter T1 geöffnet, weshalb wegen des fehlenden Meßstroms Im die Zündkreisspannung UZ auf einen geringeren Wert springt. Nach einer gewissen Überschwingzeit wird zum Zeitpunkt tm0 in einem dritten Verfahrensschritt 3 die am Zündkreis ZK anliegende Zündkreisspannung UZO vom Steuergerät erfaßt. Anschließend wird in einem vierten Verfahrensschritt 4 der Schalter T3 geschlossen, wodurch sich die Zündkreiskapazität CZ entlädt.

Die Recheneinheit RE im Steuergerät SG vergleicht in einem fünften Verfahrensschritt 5 die gemessene Zündkreisspannung UZO mit einer Sollspannung USOLL. In Abhängigkeit von der Differenz zwischen der gemessenen Zündkreisspannung UZO und der Sollspannung USOLL wird im nächsten Verfahrensschritt 6 eine Korrekturladezeit $\Delta T$ ermittelt. Wird die Grundladezeit T mit dieser Korrekturladezeit $\Delta T$ beaufschlagt, so entsteht eine Ladezeit $T \pm \Delta T$, die gewährleistet, daß die am Zündkreis abfallende Spannung nach Aufladung der Zündkreiskapazität CZ mit dieser korrigierten Ladezeit $T \pm \Delta T$ genau dieser Sollspannung USOLL entspricht. Ist nämlich die gemessene Zündkreisspannung UZO kleiner als die Sollspannung USOLL, wird zu der Grundladezeit T eine Korrekturladezeit $\Delta T$ addiert, und ist die gemessene Zündkreisspannung UZO größer als die Sollspannung USOLL, so wird von der Grundladezeit T eine Korrekturladezeit $\Delta T$ subtrahiert.

Zum Zeitpunkt t1 wird nun in Verfahrensschritt 7 ein erneuter Ladevorgang für die Zündkreiskapazität CZ gestartet. Dazu wird der Schalter T1 geschlossen, der Schalter T2 bleibt geschlossen und der Schalter T3 wird geöffnet. Im achten Verfahrensschritt 8 wird zum Zeitpunkt tm1 genau nach Ablauf der Ladezeit $T \pm \Delta T$ die Zündkreisspannung UZ1, die als erste Zündkreisspannung bezeichnet wird, gemessen. Unmittelbar nach diesem Zeitpunkt tm1 wird im neunten Verfahrensschritt 9 der Schalter T1 geöffnet und damit der Meßstrom abgeschaltet. Nach einer kurzen Einschwingphase wird zum Zeitpunkt tm2 im zehnten Verfahrensschritt 10 eine zweite Zündkreisspannung UZ2 gemessen. Diese zweite Zündkreisspannung UZ2 wird aufgrund der zuvor an die im Zündkreis befindliche Kapazität CZ angepaßten Ladezeit $T \pm \Delta T$ stets der fest vorgegebenen Spannung USOLL entsprechen. Man ist also nicht darauf angewiesen, sehr eng tolerierte Kapazitäten für die Zündkreise zu verwenden, da durch das erfindungsgemäße Verfahren eine Anpassung an Kapazitätsschwankungen, sei es daß sie herstellungs- oder temperaturbedingt sind, automatisch erfolgt.

Im elften Verfahrensschritt 11 wird die Differenz zwischen der ersten Zündkreisspannung UZ1 und der zweiten Zündkreisspannung UZ2 gebildet. Im zwölften Verfahrensschritt 12 wird nun auf folgende Weise der Widerstand RZ des Zündelements berechnet:

Wie in der Gleichung (1) ausgedrückt, läßt sich der Spannungssprung UZ1 - UZ2 durch einen bestimmten Meßstrom Im1 und der Summe aus dem Widerstand RZ des Zündelements und dem Widerstand RT2 des Schalters T2 beschreiben.

$$UZ1-UZ2 = Im1\ (RZ + RT2) \qquad (1)$$

Der Meßstrom Im1 läßt sich aus den Spannungen und Widerständen der Schaltungsanordnungen gemäß Gleichung (2) berechnen.

$$Im1 = \frac{UC - UD - UZ2 - Im1(RZ + RT2)}{RZ + RT2 + R1 + RT1}$$

$$Im1 = \frac{UC - UD - UZ2}{2(RZ + RT2) + R1 + RT1} \qquad (2)$$

In der Gleichung (2) ist UC die von der Energiereserve C gelieferte Spannung, UD die Durchlaßspannung der Diode D, RT2 der Widerstand des Schalter T2 und RT1 der Widerstand des Schalters RT1. Bis auf den Widerstand RZ des Zündelements sind alle Größen in der Gleichung (2) bekannt. Somit läßt sich nun der Widerstand RZ des Zündelements aus der Gleichung (1) mit Hilfe des Meßstrom Im1 der Gleichung (2) in der Recheneinheit RE des Steuergeräts SG sehr exakt, unabhängig von Kapazitätsschwankungen des Zündkreises, berechnen.

**Patentansprüche**

1. Verfahren zum Überwachen eines Zündkreises für eine Sicherheitseinrichtung in einem Fahrzeug, wobei der ohmsche Widerstand (RZ) eines mit einer Kapazität (CZ) in Reihe geschalteten Zündelements dadurch gemessen wird, daß die Kapazität (CZ) über eine vorgebbare Ladezeit (T ± ΔT) mit einem Meßstrom (Im) aufgeladen wird, am Ende des Aufladevorgangs eine erste am Zündkreis (ZK) abfallende Zündkreisspannung (UZ1) und nach Abschalten des Meßstromes (Im) eine zweite Zündkreisspannung (UZ2) erfaßt werden und daß aus den beiden Zündkreisspannungen (UZ1, UZ2) und dem Meßstrom (Im) der Widerstand (RZ) des Zündelements ermittelt wird, wobei die Ladezeit (T ± ΔT) so bemessen wird, daß die zweite Zündkreisspannung (UZ2) einem fest vorgegebenen Wert entspricht.

2. Verfahren nach Anspruch 1, **dadurch gekennzeichnet, daß** vor dem Meßvorgang für die beiden Zündkreisspannungen (UZ1, UZ2) die Ladezeit (T ± ΔT) dadurch bestimmt wird, daß die Kapazität (CZ) über eine feste Grundladezeit (T) aufgeladen wird, danach der Meßstrom (Im) abgeschaltet und dann die am Zündkreis (ZK) abfallende Spannung (UZO) gemessen wird, daß diese gemessene Spannung (UZO) mit einer Soll-Spannung verglichen wird und daß in Abhängigkeit von der Differenz zwischen diesen Spannungen eine Korrekturladezeit (± ΔT) ermittelt wird, aus der durch Addition mit der Grundladezeit (T) eine Ladezeit (T ± ΔT) entsteht, die gewährleistet, daß die beim anschließenden Meßvorgang gemessene zweite Zündkreisspannung (UZ2) dem fest vorgegebenen Wert entspricht.

3. Schaltungsanordnung zum Überwachen eines Zündkreises für eine Sicherheitseinrichtung in einem Fahrzeug, wobei ein Steuergerät (SG) vorhanden ist, das den ohmschen Widerstand (RZ) eines mit einer Kapazität (CZ) in Reihe geschalteten Zündelements dadurch ermittelt, daß es einen Meßstrom (Im) zum Aufladen der Kapazität (CZ) für eine vorgebbare Ladezeit (T ± ΔT) einschaltet, am Ende der Ladezeit eine erste am Zündkreis (ZK) abfallende Zündkreisspannung (UZ1) mißt, danach den Meßstrom (Im) abschaltet und eine zweite Zündkreisspannung (UZ2) mißt, und daß das Steuergerät (SG) aus beiden gemessenen Zündkreisspannungen (UZ1, UZ2) und dem Meßstrom (Im) den Widerstand (RZ) des Zündelements berechnet, und daß das Steuergerät (SG) die Ladezeit (T ± ΔT) so bemißt, daß die zweite Zündkreisspannung (UZ2) einem fest vorgegebenen Wert entspricht.

4. Schaltungsanordnung nach Anspruch 3, **dadurch gekennzeichnet, daß** das Steuergerät (SG) vor dem Meßvorgang für die beiden Zündkreisspannungen (UZ1, UZ2) die Ladezeit (T ± ΔT) bestimmt, indem sie den Meßstrom (Im) einschaltet und die Kapazität (CZ) über eine feste Grundladezeit (T) auflädt, danach den Meßstrom (Im) abschaltet und dann die am Zündkreis (ZK) abfallende Spannung (UZO) mißt, daß das Steuergerät (SG) die gemessene Spannung (UZO) mit einer Soll-Spannung vergleicht und in Abhängigkeit von der Differenz zwischen den beiden Spannungen eine Korrekturladezeit (± ΔT) ermittelt, die durch Addition mit der Grundladezeit (T) zu einer Ladezeit (T ± ΔT) führt, die gewährleistet, daß die beim anschließenden Meßvorgang gemessene zweite Zündkreisspannung (UZ2) dem fest vorgegebenen Wert entspricht.

**Claims**

1. Method for monitoring a firing circuit for a safety device in a vehicle, the ohmic resistance (RZ) of a firing element which is connected in series with a capacitor (CZ) being measured by charging the capacitor (CZ) with a measuring current (Im) over a predefinable charging time (T ± ΔT), sensing a first firing circuit voltage (UZ1) which drops across the firing circuit (ZK) at the end of the charging process and sensing a second firing circuit voltage (UZ2) after the measuring current (Im) is switched off, and the resistance (RZ) of the firing element being determined from the two firing circuit voltages (UZ1, UZ2) and the measuring current (Im), the charging time (T ± ∆T) being dimensioned in such a way that the second firing circuit voltage (UZ2) corresponds to a permanently predefined value.

2. Method according to Claim 1, **characterized in that**, before the measuring process for the two firing circuit voltages (UZ1, UZ2), the charging time (T ± ∆T) is determined by charging the capacitor (CZ) over a fixed basic charging time (T), then switching off the measuring current (Im) and then measuring the voltage (UZ0) which drops across the firing circuit (ZK), comparing this measured voltage (UZ0) which is a set point voltage and determining, as a function of the difference between these two voltages, a correction charging time (± ∆T) from which, by addition to the basic charging time (T), a charging time (T ± ∆T) is obtained which ensures that the second firing circuit voltage (UZ2) measured during the subsequent measuring process corresponds to the permanently predefined value.

3. Circuit arrangement for monitoring a firing circuit for a safety device in a vehicle, a control unit (SG) being provided which determines the ohmic resistance (RZ) of a firing element which is connected in series with a capacitor (CZ), by switching on a measuring current (Im) in order to charge the capacitor (CZ) for a predefinable charging time (T ± ∆T), measuring a first firing circuit voltage (UZ1) which drops across the firing circuit (ZK) at the end of the charging time, and then switching off the measuring current (Im) and measuring a second firing circuit voltage (UZ2), and in that the control unit (SG) calculates the resistance (RZ) of the firing element from the two measured firing circuit voltages (UZ1, UZ2) and the measuring current (Im), and in that the control unit (SG) dimensions the charging time (T ± ∆T) in such a way that the second firing circuit voltage (UZ2) corresponds to a permanently predefined value.

4. Circuit arrangement according to Claim 3, **characterized in that** the control unit (SG) determines the charging time (T ± ∆T) before the measuring process for the two firing circuit voltages (UZ1, UZ2) by switching on the measuring current (Im) and charging the capacitor (CZ) over a fixed basic charging time (T), then switching off the measuring current (Im) and then measuring the voltage (UZ0) which drops across the firing circuit (ZK), and **in that** the control unit (SG) compares the measured voltage (UZ0) with a set point voltage and determines, as a function of the difference between the two voltages, a correction charging time (± ∆T) which gives rise, by addition to the basic charging time (T), to a charging time (T ± ∆T) which ensures that the second firing circuit voltage (UZ2) measured during the subsequent measuring process corresponds to the permanently predefined value.

## Revendications

1. Procédé pour surveiller un circuit d'amorçage d'un système de sécurité dans un véhicule, selon lequel la mesure de la résistance ohmique (RZ) d'un élément d'amorçage monté en série avec une capacité (CZ) est effectuée en chargeant cette capacité (CZ) pendant un temps de charge préfixé (T±∆T) en utilisant un courant de mesure (Im), en saisissant dans le circuit d'allumage (ZK) à la fin de cette charge une première tension (UZ1), puis après coupure du courant de mesure (Im) une seconde tension (UZ2), pour déterminer à partir des deux tensions (UZ1, UZ2) et du courant de mesure (Im), la résistance (RZ) de l'élément d'amorçage,
**caractérisé en ce que**
le temps de charge (T±∆T) est dimensionné de manière que la seconde tension (UZ2) du circuit d'amorçage corresponde à une valeur préfixée.

2. Procédé selon la revendication 1,
**caractérisé en ce que**
avant l'opération de mesure des deux tensions (UZ1, UZ2) du circuit d'amorçage le temps de charge (T±∆T) est défini de manière que la capacité (CZ) soit chargée au bout d'un temps de charge de base (T) fixe, ensuite le courant de mesure (Im) est coupé et la tension (UZO) chutant dans le circuit d'amorçage (ZK) est mesurée et comparée à une tension de consigne, et en fonction de la différence entre ces tensions, il est établi un temps de charge correctif (±∆T) qui, ajouté au temps de charge de base (T) donne un temps de charge (T±∆T) qui garantit que la seconde tension (UZ2) dans le circuit d'amorçage, établie lors de l'opération de mesure qui suit, correspond à la valeur préfixée.

3. Circuit pour surveiller le circuit d'amorçage d'un dispositif de sécurité dans un véhicule comportant un appareil de commande (SG) qui établit la mesure de la résistance ohmique (RZ) d'un élément d'amorçage monté en série avec une capacité (CZ) en envoyant pour charger la capacité (CZ) un courant de mesure (Im) pendant un temps de charge préfixé (T±∆T) et en mesurant à la fin de cette charge une première tension (UZ1) diminuée dans le circuit d'amorçage, puis après coupure du courant de mesure (Im) une seconde tension (UZ2) du circuit d'amorçage, l'appareil de commande (SG) calculant à partir des deux tensions mesurées (UZ1, UZ2) et du courant de mesure (Im), la résistance (RZ) de l'élément d'amorçage, et en dimensionnant le temps de charge (T±∆T) de sorte que la seconde tension (UZ2) corresponde à une valeur préfixée.

4.  Circuit selon la revendication 4
    **caractérisé en ce que**
    l'appareil de commande (SG) avant d'effectuer les mesures de deux tensions (UZ1, UZ2) définit le temps de charge (T ± ΔT) en envoyant le courant de mesure (Im) et en chargeant la capacité (CZ) pendant un temps de charge de base (T) fixe, puis en coupant le courant de mesure (Im) et en mesurant la tension (UZO) en chute dans le circuit d'amorçage, et l'appareil de commande (SG) compare la tension mesurée (UZO) à une tension de consigne et en fonction de la différence entre ces deux tensions, définit un temps de charge correctif (±ΔT) qui, additionné au temps de charge de base (T) donne un temps de charge (T ± ΔT) qui garantit que dans la mesure qui suit, la valeur mesurée de la seconde tension du circuit d'amorçage (UZ2) correspond à la valeur préfixée.

# Fig. 1

# Fig. 2

**Fig. 3**

```
┌─────────────────────────┐
│  T1,T2 schließen        │ ──── 1
│  CZ aufladen über T     │
└─────────────────────────┘
            │
            ▼
┌─────────────────────────┐
│      T1 öffnen          │ ──── 2
└─────────────────────────┘
            │
            ▼
┌─────────────────────────┐
│     Messung UZ0         │ ──── 3
└─────────────────────────┘
            │
            ▼
┌─────────────────────────┐
│  T3 schließen           │ ──── 4
│  CZ entladen            │
└─────────────────────────┘
            │
            ▼
┌─────────────────────────┐
│   Vergleich UZ0         │ ──── 5
│     mit USOLL           │
└─────────────────────────┘
            │
            ▼
┌─────────────────────────┐
│    Ermittlung ΔT        │ ──── 6
└─────────────────────────┘
            │
            ▼
┌─────────────────────────┐
│ T3 öffnen, T1 schließen │ ──── 7
│ CZ aufladen über T±ΔT   │
└─────────────────────────┘
            │
            ▼
┌─────────────────────────┐
│     Messung UZ1         │ ──── 8
└─────────────────────────┘
            │
            ▼
┌─────────────────────────┐
│      T1 öffnen          │ ──── 9
└─────────────────────────┘
            │
            ▼
┌─────────────────────────┐
│     Messung UZ2         │ ──── 10
└─────────────────────────┘
            │
            ▼
┌─────────────────────────┐
│   Differenzbildung      │ ──── 11
│     UZ1 - UZ2           │
└─────────────────────────┘
            │
            ▼
┌─────────────────────────┐
│    Berechnung RZ        │ ──── 12
└─────────────────────────┘
```